Europäisches Patentamt

(19) European Patent Office

Office européen des brevets

(11) Publication number: **0 176 736**
**B1**

(12) **EUROPEAN PATENT SPECIFICATION**

(45) Date of publication of patent specification: **13.07.88**

(51) Int. Cl.⁴: **C 23 C 18/30**, C 23 C 18/38, H 05 K 3/06, H 05 K 3/18

(21) Application number: **85110437.2**

(22) Date of filing: **20.08.85**

(54) **Process for selective metallization.**

| | |
|---|---|
| (30) Priority: **04.09.84 US 646978** | (73) Proprietor: **KOLLMORGEN TECHNOLOGIES CORPORATION**<br>**66 Gatehouse Road**<br>**Stamford Connecticut 06902 (US)** |
| (43) Date of publication of application:<br>**09.04.86 Bulletin 86/15** | |
| | (72) Inventor: **Moisan, Michael P.**<br>**19 Sherman Street**<br>**Huntington, NY 11743 (US)**<br>Inventor: **Cook, Joseph P.**<br>**304 Weymouth Street**<br>**Dix Hills, NY 11746 (US)** |
| (45) Publication of the grant of the patent:<br>**13.07.88 Bulletin 88/28** | |
| (84) Designated Contracting States:<br>**AT CH DE IT LI NL SE** | |
| | (74) Representative: **Königseder, geb. Egerer, Claudia**<br>**Zugspitzstrasse 65**<br>**D-8104 Grainau (DE)** |
| (56) References cited:<br>**DE-A-2 716 418**<br>**DE-A-2 818 489**<br>**DE-B-2 709 928**<br>**GB-A-1 529 151**<br>**US-A-4 264 646** | |

Courier Press, Leamington Spa, England.

# 0 176 736

**Description**

This invention relates to forming a metal pattern on the surface of a substrate and to the products resulting therefrom. More particularly, this invention relates to processes for forming metal patterns on insulating substrates suitable for the manufacture of printed circuit boards by metal plating, e.g., by electroless metal plating, and for forming metallic interconnecting holes or cavities suitable for the manufacture of wire scribed boards.

It is well known to apply an electroless metal plating to an insualting substrate such as plastic, by depositing a noble metal, activator or catalyst suitable for rendering the substrate receptive for electroless metal plating, and then exposing the substrate to an electroless metal plating solution.

Various techniques have been used to form a circuit pattern on a desired circuit-forming area, including through-holes, on an insulating substrate by electroless metal plating including fully additive processes for obtaining conductive patterns by selective deposition of conductive material on an insulating substrate, wherein the entire thickness of conductors is built up by electroless metal deposition.

Plating processes have also been employed in the production of circuit boards with conductor patterns formed by insulated wires affixed to, or embedded in, an insulating substrate and provided with metallized through-holes or cavities.

In one embodiment, the laminate substrate and the adhesive layer provided with the wire conductors both contain a catalyst for electroless deposition. A plating mask is applied before forming the holes or cavities to be metallized. The substrate is then immersed in an electroless metal plating bath to deposit metal on the exposed areas. Finally, the mask is stripped, and the substrate is subjected to post-treating operations.

Because the catalytic material constitutes only part of the substrate and adhesive layer, e.g., part of a reinforced epoxy-glass laminate substrate, its inherent catalytic effect is weak. Also, the electrolessly deposited metal coating tends to slowly cover glass fibers compared to resinous areas, and at times may contain voids in the metal layer where bundles of glass fibers exist at the hole wall surface in the substrate.

Another additional difficult plating problem is encountered with respect to plating so called "blind vias" which are cavities, having a diameter in the range of 160 to 600 µm, extending from the surface and only partly through the substrate.

The reliable manufacture of high-quality products has required extensive quality control primarily due to the fact that the precatalyzed laminate has low catalytic activity. To compensate for low catalytic activity on hole walls in the laminate, high activity plating baths have been used. Such plating baths are, however, difficult to control and tend to be unstable forming indiscriminate metal deposits, i.e., copper dust particles suspended in the solution and dropping to the bottom of the bath tank. Copper dust particles will also deposit on the product. These dust particles are incorporated into the metal deposit formed interrupting the grain structure and forming nucleation sites for cracks, breaks or fissures in the deposited metal layer on the substrate surface or on hole walls. The breaks or fissures may be formed during metallization or during soldering or other operations in the course of the manufacture and use of such circuit boards.

Voids in the copper layer forming the "wrap-around area" are an additional quality control problem of additively plated wire scribed boards where the wire is severed when the hole is formed. A "wrap-around area" forms when insulation surrounding the wire (e.g., a polyimide jacket) is etched back around a hole cleaning operation. The insulation is etched back typically from about 0.005 mm to about 0,5 mm from the intersection of the wire with the hole wall. Then, this "wrap-around area" must be completely filled with a copper deposit which wraps around the wire where it intersects the hole wall. It is essential that a void-free and crack-free layer of copper be deposited in this area to produce a reliable product. Additive plating processes have also been employed for producing printed circuits on non-catalytic substrates. In one process, a mask pattern is laid down on the surface of an insulating substrate and the entire surface, including both the mask and the exposed substrate areas, is treated with an agent comprising catalytic species for promoting the electroless deposition of metal, and then with a metal deposition solution. Metal deposits both on the exposed substrate areas and on the mask-covered areas. The mask and the metal coating formed on the mask are subsequently removed to leave only the desired metal conductor pattern. In this process, the edges of the resulting conductors have a tendency to be ragged and hence resolution is not satisfactory for high conductor density applications.

Another suggested process involves first sensitizing and activating thus rendering the entire surface of an insulating substrate receptive to electroless metallization before applying a mask pattern. After the mask pattern is applied, the entire surface is treated with an electroless metal deposition solution. In this method, metal deposits predominantly on the exposed substrate areas. While resolution is good, this method has the serious disadvantages, e.g., in that sensitization and activation of the entire surface of the substrate produces a surface which tends to have a relatively low resistivity between conductors deposited thereon, and manufacturing handling problems, in that during the long processing sequence between activating and finally electrolessly plating, the catalytic surface is highly sensitive to contamination, scratching, and the like which can result in defective circuits.

Another additive plating process for a non-catalytic substrate is described in US—PS 4,388,351. According to such process, a printed circuit board is formed by applying a removable, negative pattern mask onto the surface of a non-catalytic substrate, forming micropores in the unmasked substrate areas

2

corresponding the desired conductor pattern, sensitizing the entire surface consisting of the exposed portion of the substrate and the masking layer, to provide it with species capable of catalyzing electroless metal deposition, optionally electrolessly depositing a thin porous flash metal deposit having a thickness of from 0,075 to 0,5 µm, removing the mask and thereby the catalytic species and the flash electroless metal deposited thereon, and electrolessly depositing additional metal onto the flash deposit remaining on the substrate. This process has the deficiency of poor control of conductor edge definition due to the mask stripping operation. The areas next to the conductor edges were masked during adhesion promotion and are, therefore, devoid of micropores and catalytic sites.

When a thick copper buildup, e.g. about 35 µm, is required, copper adherently deposits on the center area of the conductor which has been adhesion promoted, and may have a width as small as 125 µm. The deposit grows sidewise about the same, i.e., about 35 µm on each side of the initial conductor trace. Thus, 70 µm of a conductor width of 195 µm are not securely bonded to the substrate.

Still another additive plating process for a non-catalytic substrate is described in US-PS 3,799,816. According to this process, plated through-hole printed circuit boards containing thereon a printed circuit pattern are prepared by forming holes in an insulating substrate at predetermined points, applying a hydrophobic insulating mask on the circuit pattern leaving the holes exposed, contacting the substrate with an activator solution comprising stannous ions and precious metal ions to render the hole walls, but not the exposed surface of the hydrophobic mask, sensitive to the reception of electroless metal, contacting the substrate with an electroless metal deposition solution to preferentially deposit electroless metal on the exposed areas of the substrate including the hole walls, but not on the exposed surface of the hydrophobic mask, and treating the substrate with an etching solution a number of times to remove minor deposits of metal on the mask while leaving the electroless metal deposit on the exposed areas substantially unimpaired. US-PS 3,443,988 proposes a process for preventing deposition of electroless metal on masks by applying materials capable of neutralizing surface imperfections present on masking resins. However, since printed circuits require a long plating time, deposition of metal on masks is not prevented by such process.

US-PS 4,293,592 and 4,151,313 describe processes of preventing deposition of electroless metal on masks by utilizing hydrophobic masks containing pigments or additives to inhibit metal deposition in combination with organic acid washing solutions to wash the activation from the mask.

Incorporated in the epoxy resin-based mask compositions are materials which inhibit the deposition on the noble metal catalyst on the mask so that smaller quantities of noble metal are deposited on the surface of the mask and on the areas of the substrate corresponding the circuit pattern. According to this prior art technique, the masking material must contain a solid solution of oxides of titanium, nickel and antimony. In addition, the noble metal which does deposit on the mask must be removed with a solution of hydrochloric acid and ammonium persulfate. In accordance with US-PS 4,293,592 the masking material contains 2 to 20 parts by weight of inhibitors such as sulfur, selenium, arsenic, zinc, antimony, etc., or oxides or salts thereof. The noble metal which does deposit on the mask is removed with an aqueous solution of an organic acid and hydrochloric acid and/or nitric acid.

These processes teach away from applicant's invention because even though they disclose the use of, inter alia, an alkaline accelerator solution, there is no suggestion of keeping such alkali solution in contact with the substrate for a sufficient amount of time to remove essentially all catalyst species from the surface of the masks and by doing this avoid all other complicated steps. Accelerator solutions have been used in electroless plating processes for many years. Their basic function is to complete the reaction between stannous chloride and palladium chloride present in the catalyzing solution, also referred to as the activator, and dissolve the resulting stannic tin. This results in active noble metal (palladium) sites on the circuit board substrate. At one time, some accelerator solutions comprised alkaline solutions containing complexing agents to dissolve the tin. However, acidic accelerators containing acids such as hydrogen fluoride, dilute fluoroboric acid, ammonium bifluoric acid, perfluoric acid and oxalic acid, have been preferred. These acidic accelerator solutions leave in place the activator sites contaminating the mask.

It is an object of this invention to provide an improved process for electrolessly plating a wire scribed circuit board having through-holes and/or blind vias wherein a metal layer, e.g., copper, which is void-free and free of fissures or breaks, is deposited on the hole walls and the wrap-around area.

An object of this invention is to provide a process which does not rely on difficult to operate, highly active electroless copper plating baths for forming connections in wire scribed circuit boards.

Another object of the invention is to provide a process for selective electroless deposition of metal on a printed wiring substrate in which activator deposited on a hydrophobic mask and the surface of the board is selectively removed from the mask by treatment with an alkaline solution.

Other objects and advantages will be set forth in part herein and in part will be obvious herefrom or may be learned by practice with the invention and the appended claims.

The invention is based on the discovery that an alkaline solution containing a chelating agent selectively removes essentially all of the catalytic species deposited on a hydrophobic mask on the substrate without substantially reducing the catalytic activity in catalyzed areas of the substrate free of mask.

It has further been found that such solution may, at the same time, serve as 'accelerator' enhancing catalytic activity by removing tin from a palladium-tin activator in the exposed areas of the substrate surface.

It is surprising and unexpected that the same solution which 'accelerates' and thereby enhances the activity of the palladium activator remaining substantially undisturbed on the substrate also removes palladium activator from the hydrophobic mask.

It has been found that exposure to certain alkaline solutions comprising chelating agents as accelerators for a predetermined time period (1) is sufficient to remove essentially, all of the catalytic species sites deposited on an insulating hydrophobic mask, with the remaining surface concentration preferably being 0,002 mg/cm$^2$ or less, and (2) does not sufficiently reduce the concentration of catalytic species sites on unmasked substrate surface areas and on walls of holes and/or blind vias to cause plating problems, e.g., the formation of voids during subsequent metal plating.

The invention comprises a process for selective metallization of insulating substrates comprising the steps of applying a hydrophobic masking layer to said substrate, said masking layer covering all areas not to be metallized and leaving exposed areas to be provided with a metal deposit; contacting the substrate provided with said masking layer with an agent capable of depositing catalytic species for promoting metal deposition; treating the said substrate and masking layer with a solution for removing catalytic species from the surface of the masking layer; and contacting the substrate with a solution capable of electrolessly forming metal deposits on the unmasked areas of said substrate, characterized in that said solution for removing catalytic species from the surface of said masking layer comprises a chelating agent for the catalytic species and has a pH of between 10 and 14; and that the surface is exposed to said solution for a time sufficient for removing essentially all the catalytic species from the masking layer and leaving catalytic species on unmasked portions of the substrate.

It was further found that said time period can be shortened by agitation and that the time in the alkaline solution required to remove essentially all of the catalytic species sites deposited on the mask is proportional to the degree of solution agitation.

With vigorous stirring, 5 to 20 minutes immersion in the alkaline solution of the invention acting at the same time as accelerator is effective for removal of the catalytic sites from the mask, but the formation of an initial electroless metal deposit is slowed down with extended exposure as discussed below. For example, an initial electroless copper deposit was found to appear in 5 minutes if an epoxy glass panel was immersed for 10 minutes in the vigorously stirred alkaline accelerator solution; and in 10 minutes if the panel was immersed for 20 minutes in said vigorously stirred accelerator solution. In an alkaline accelerator solution which is not stirred, 30 minutes immersion of the panel is preferred to remove the catalyst from the surface of the mask; and adhesive coated insulating substrates can be immersed for up to 2 hours in a still alkaline accelerator solution with only a slight increase in the time required for formation of the initial electroless metal layer in the unmasked areas.

A cleaner-conditioner solution known in the art may be advantageously used according to this invention to degrease the substrate surface including walls of the holes and render such surfaces receptive to the deposition of catalytic species.

This invention further provides an improvement in a process for depositing metal on a wire scribed circuit board having at least one insulating wire affixed to a surface of a substrate or embedded therein and having at least a portion of the surface of the substrate covered with a hydrophobic mask and having at least one hole and/or blind via in the substrate and intersecting the wire wherein the walls of the hole and/or blind via and the intersected wire are metallized by metal deposition, the improvement comprising contacting the surface of the substrate including said walls with a catalyst solution comprising an agent suitable for rendering exposed surfaces receptive to metal deposition; contacting the entire surface including said hole walls and said hydrophobic mask with an alkaline solution, preferably an accelerator solution comprising a chelating agent for a time period sufficient to selectively remove substantially all of the catalyzing sites, e.g., the noble metal sites, from the hydrophobic mask surface, while leaving adequate catalytic sites in the unmasked areas and preferably accelerating the catalytic sites on said walls, said solution having a pH of between 10 and 14; and depositing a metal layer on the catalyzed surface of said walls.

In another aspect, this invention provides an improved process for producing printed circuit conductor networks on surfaces of an insulating substrate by electroless metal plating, which substrate optionally includes one or more holes or cavities for electrical connections, said process including the steps of applying a hydrophobic and insulating mask onto a surface of the substrate, whereby portions of the surface are left unmasked and exposed; contacting with a catalyst comprising an agent capable of promoting metal deposition on the mask and any unmasked portion of the substrate surface including walls of holes or cavities, if present; contacting the entire surface of the substrate and the mask with an accelerator solution; removing the catalytic species from the surface of the mask; and contacting the substrate surface with an electroless metal plating solution to form an electroless metal plating on the unmasked portion of the substrate surface and on the walls of the holes; the improvement comprising using as the accelerator solution a chelating agent in an alkaline solution having a pH of between 10 and 14, and contacting the substrate surface with such alkaline accelerator solution for a time period sufficient to remove essentially all the catalytic species from the surface of the mask and leave catalytic species on the unmasked portion of the substrate surface and on the walls of the holes.

4

Although the invention will be described principally in terms of the production of plated through-hole wire scribed boards, printed circuit boards and other metallized products advantageously may be produced by following the teachings herein.

Circuit boards produced according to this invention use certain insulating and hydrophobic masks which repel and substantially are not wetted by activating and/or sensitizing solutions commercially used in the production of printed wiring boards. As a result, when such mask surfaces contact such solutions, they are rendered receptive to electroless metal deposition to a lesser degree than unmasked boards.

The term 'activator' is used in the sense recognized by those skilled in the art of electroless plating to contemplate means to render a non-conductive material receptive to the electroless deposition of a metal. Synonyms are 'seeder', 'catalyst' or 'sensitizer'. Most frequently, palladium-containing solutions are used commercially as activators.

The term 'hydrophobic' as used herein, generically refers to any resinous or plastic material which is not wetted by the solutions employed in the art to render insulating substrates catalytic to the reception of electrolessly deposited metal.

Wire scribed circuit boards may be prepared by the procedure described in US-PS 3,646,572; 3,674,914 and 4,097,864. In such procedure, insulating wire circuit patterns are scribed on the substrate surface provided with an adhesive layer, both, the substrate and the adhesive comprising a component catalytic to electroless deposition of metal. Typically, the wire is a 0,06 to 0,16 mm diameter copper wire insulated with a 0,01 mm thick polyimide jacket.

After the wiring step, a layer of glass cloth impregnated with epoxy resin and typically containing a catalytic filler is laminated over the wire scribed circuit pattern. The board is then coated with a hydrophobic mask, typically a polyethylene film. Holes are drilled through the mask into the panel cutting through the scribed wire in locations where electrical connections to said wires are required.

Resin smear formed on the wire face at the intersection of the wire with the hole wall is removed by an oxidizing solution, and the insulation on the wire is etched back to expose a small portion of the copper wire. Then, the hole walls are treated sequentially with a cleaner-conditioner solution, an activator solution and an accelerator solution.

The hydrophobic mask substantially prevents the surface from being rendered as sensitive to electroless metal deposition as the unmasked hole walls. Activator thus is deposited on the hole walls in more than two, preferably more than five times, the concentration that it is deposited on the mask due to differences in wettability of their respective surfaces by the activator solution. The surface of the substrate and the hole walls are then treated with an alkaline accelerator of this invention which not only accelerates the activator deposited on the hole walls, but also removes the activator deposited on the mask. After a rinsing step, the substrate is contacted with an electroless metal deposition solution to metallize the walls of the holes. The metal deposit can be built up to the required thickness by electroless deposition alone, or, when the conductor pattern is suitable, the initial electroless plating can be followed by electroplating.

Instead of using the solution acting as accelerator and removing activator from the masking surface, a separate alkaline chelating solution may be used for removal of activator from the mask surface prior to or after a conventoinal accelerator solution treatment.

In another embodiment of the invention, a printed circuit pattern is formed on an insulating substrate using a hydrophobic mask. Holes are optionally provided in the substrate by any method such as by drilling, piercing or punching. The substrate may be treated to adhesion promote its unmasked portions and/or remove any resin smears from hole walls. Treatment with an oxidizing solution is the preferred method to adhesion promote the unmasked portions and/or remove any resin smears. Then, the surface of the substrate and the hole walls are treated with a cleaner-conditioner solution to condition the adhesion promoted surface including the hole walls to receive the activating solution. After the substrate is rinsed, it is contacted with the activator solution, e.g., a palladium-tin activator, to catalyze the conductor pattern and the walls of the holes to the reception of electroless metal. As discussed above, the hydrophobic mask substantially prevents the masked portion of the surface from being rendered as sensitive to electroless metal deposition as the unmasked portion of the surface and the hole walls. The subsequent treatment with an alkaline accelerator solution of this invention not only accelerates the activator deposited on the unmasked portions of the substrate and the hole walls, but also removes the activator deposited on the mask. The required conductors are then formed by electroless metal deposition.

Suitable hydrophobic resins for mask compositions include silicone resins, polyethylene resins, fluorocarbon resins, e.g., polytetrafluoroethylene, polyurethane resins, acrylic resins, and mixtures of the foregoing. The hydrophobic resins may be used by themselves, but preferably they are used in combination with other resinous materials, for example, any of the resins known in the art for use as the insulating substrate, in an amount sufficient to provide the composition with hydrophobic characteristics. Particularly useful hydrophobic masks may be produced by combining epoxy novolak resins to obtain a smooth, glossy surface after curing.

The processes of the invention contemplate the use of a substrate having a surface comprising an adherent resinous layer, suitable for treatment to form a hydrophilic, microporous surface.

Cleaner-conditioner solutions are well known in the art and are used to remove light oils, fingerprints, and other surface contaminants and to condition hole walls for activation and electroless copper plating.

An alkaline solution of this invention containing the chelating agent(s) and having a pH between 10 and

5

**0 176 736**

14 may be prepared by well known techniques such as adding the chelating agent and sufficient sodium or potassium hydroxide to an aqueous solution to produce the desired pH. Suitable chelating agents may be selected from among amino acids, alkanolamines and polyfunctional carboxylates.

Suitable amino acids include glycine and nitrilotriacetic acid.

Suitable alkanolamines include hydroxethylenediamine triacetic acid (HEDTA), a salt of HEDTA and ethylene diamine tetrapropanol.

Suitable polyfunctional carboxylates include citrates and tartrates.

The chelating agent is present in the alkaline solution in an amount greater than about 0,01 % by weight, preferably greater than about 0,1 % by weight and more preferably greater than about 0,4 % by weight, of the alkaline solution. The chelating agent also is present in the alkaline solution in an amount less than about 10 % by weight, preferably less than about 5 % by weight, and most preferably less than about 2 % by weight of the alkaline solution.

The following examples illustrate processes in accordance with the invention.

Example 1

Wire scribed panels were prepared by coating a layer of glass cloth impregnated with B-staged epoxy containing catalytic filler on both sides with catalytic adhesive 0,1 mm thick. This was laminated to a sheet of catalytic epoxy glass laminate 1,6 mm thick. Wire circuit patterns were scribed on the adhesive surface using 0,16 mm diameter copper wire coated with 0,01 mm thick polyimide insulation. After the wiring step, a layer of glass cloth impregnated with an epoxy resin containing a catalytic filler was laminated by heat and pressure over the wire scribed circuit pattern. The panels were coated on both surfaces with a polyethylene film bonded by a pressure sensitive adhesive. Holes, 1,17 mm in diameter, were drilled through the panels intersecting and cutting through the scribed wire at points where electrical concentions were to be made. Next, resin smear, formed on the wire where the wire end forms part of the hole wall, was removed by immersion for 1 hour at 60°C in a permanganate oxidizing solution containing 60 g/l of KMnO$_4$ and 0,2 g/l of fluorinated alkyl carboxylate at a pH of 12,5, using a standard rack agitator operating at 35 cycles per minute, each cycle consisting of a 50 mm reciprocating stroke.

After the resin smear removal, neutralization of the permanganate was accomplished by immersion for 3 minutes in an aqueous solution of stannous chloride, 30 g/l, and hydrochloric acid, 330 ml/l, followed by immersion in a solution of stannous chloride, 3 g/l, and hydrochloric acid, 330 ml/l for another 3 minutes. After rinsing with water to remove the neutralizing solutions, the board was then immersed for 20 minutes at 60°C, using the same rack agitation conditions described above, in an alkaline solution comprising 150 g/l of NaOH and 1 g/l of paranonylphenoxy-polyglycidol surfactant, followed by vigorous rinsing with water.

The thus treated board was then immersed in 40 g/l of an alkaline cleaner-conditioner for 5 minutes at 60°C and agitated as described above. After rinsing with water, the board was immersed in a sodium persulfate solution (60 g/l±5 g/l) at a pH of 2,0 to 2,5 at 40°C for between 2 1/2 and 3 minutes under the same rack agitation conditions described above, rinsed with water again, followed by immersion in a 100 ml/l solution of sulfuric acid, and rinsed again in water for about 3 minutes.

The board was then immersed for 2 minutes in a predip solution containing 5 g/l of stannous chloride and 200 g/l of sodium chloride and having a pH of up to 0,5 under the rack agitation conditions previously described. This procedure was followed by activating in a solution of Pd (0,15 g/l), Sn (11 g/l), Cl (145 g/l) and adjusting the pH at less than 0,5 by adding 32 ml/l of the solution prepared according to Example 1 of US-PS 3,961,109 to 970 ml of a 200 g/l sodium chloride brine for 5 minutes at a temperature of between 22°C and 25°C under the same rack agitation conditions previously described.

After rinsing in water, the board was immersed in the alkaline accelerator solution containing 3,0 g/l of NaOH, 11,25 ml/l of a 41% solution of hydroxethylenediaminetriacetate (HEDTA), and an organic phosphate wetting agent, nonyl phenoxy polyglycidyl phosphate, for 5 minutes with vigorous stirring of the accelerator solution and under the same rack agitation conditions described above. The resulting board was rinsed in water and electrolessly plated as described below.

The board was immersed in an electroless plating bath solution containing 8 g/l of CuSO$_4$ · 5H$_2$O, 3,5 to 4,0 ml/l of HCHO, 35 g/l of Na$_4$ EDTA and 0,14 ml/l of nonyl phenoxy polyglycidyl phosphate and 0,05 millimoles/l of cyanide (as measured by Orion Cyanide Ion Specific Electrode). The bath temperature was 70—72°C and the pH between 12,0 and 12,1 (measured at 25°C). During electroless deposition, the board was constantly agitated using a rack agitator operating at 30 cycles per minute, each cycle consisting of a 50 mm reciprocating stroke.

After about 20 hours, the board was removed from the copper bath solution and rinsed with water. The wired circuit board obtained had a uniform and smooth copper deposit on the walls of the holes. The copper was free of voids and nodules. Essentially no detectable copper dust particles or flecks were deposited on the polyethylene mask.

The polyethylene mask was stripped and the board subjected to conventional post plating operations, such as mechanical treatments, baking, cutting to size and drilling mounting holes.

Example 2

The procedure of Example 1 was repeated six times except as follows:

1. Following the smear removal and neutralization treatments, each board was immersed in an

6

aqueous cleaner-conditioner solution for 6 min. at 60°C using a rack agitator operating at 35 cycles per minute, each cycle consisting of a 50 mm reciprocating stroke. This cleaner-conditioner solution contains 5,0 g/l triethanolamine, 3 g/l of a quaternary ammonium surfactant and 4,0 g/l of a nonylphenoxy-polyglycidol surfactant at a pH of 10,8.

2. Each board was rinsed in ambient running water for 5 minutes.

3. Each board was immersed for 1 minute at ambient temperature in a mild copper etching solution comprising 60 g/l sodium persulfate and sulfuric acid to pH 2,5 and using the rack agitation conditions described in step 1 above.

4. Each board was rinsed in running water for 5 minutes.

5. Each board was immersed for 1 minute in a deoxidizing solution comprising 900 ml/l water, 100 ml/l sulfuric acid and using the rack agitation conditions described in step 1 above.

6. Each board was rinsed in running water for 5 minutes.

One board, designated A, was processed directly in the electroless copper solution of Example 1. The other five boards, designated B, C, D, E and F, were treated according to the following procedure:

7. Each board was immersed for 3 min. at ambient temperature in an acidic solution of 5,0 g/l tin chloride dissolved in a 200 g/l sodium chloride brine.

8. Each board was immersed for 10 min, at 40°C in the palladium-tin-chloride solution of Example 1 and using the rack agitation conditions described in step 1 above.

9. Each board was rinsed in running water for 5 minutes.

Board B was treated with a conventional aqueous acidic accelerator solution by immersing for 2 min. in dilute aqueous fluoroboric acid solution with mild stirring and using the rack agitation conditions described in step 1 above. The accelerator solution was mildly stirred using the two-speed mixer described above in Example 1 operating between 600 and 1000 revolutions per minute. Board B was then rinsed in running water for 5 min. and immersed in the electroless copper plating bath solution.

Boards C, D, E and F were treated with the alkaline accelerator solution of Example 1. This accelerator solution was vigorously stirred and the panels agitated using the rack agitation conditions described above in step 1.

Board C was immersed in this alkaline accelerator solution for 1 1/2 minutes.

Board D was immersed for 3 minutes.

Board E was immersed for 5 minutes.

Board F was immersed for 10 minutes.

After the alkaline accelerator treatment, boards C, D, E and F were all rinsed in running water for 5 minutes and then placed in the electroless copper plating bath disclosed in Example 1.

After 5 minutes in the electroless copper plating bath, all the boards were examined. Board A had no copper plating. Board B had a copper film through the holes but approximately 30% to 40% of the polyethylene mask was also coated with electrolessly deposited copper. Boards C, D and E each had a film of copper plating on the hole walls. Board F had apparently no copper plating.

Board C, which had been immersed for 1 1/2 minutes in the alkaline accelerator, had some copper plated on the polyethylene mask.

Board D, which has been immersed in the alkaline accelerator for 3 minutes, had slight plating on the mask.

Board E, which had been immersed in the alkaline accelerator for 5 minutes, had a clear mask surface.

The boards were removed from the copper plating bath after 5 hours and examined again. In board A, the copper was growing on the epoxy in the hole but had not yet knitted over the glass fiber bundles, and over the adhesive layer that is, there were still a large number of voids in the copper deposit.

In board F, although there were still some voids over fiber bundles, the copper had already completely covered the epoxy portions of the hole walls and the adhesive layer. The B, C, D and E boards all had approximately 8 μm of copper uniformly throughout the holes. Board B also had 8 μm of copper on the surface of the polyethylene mask while boards C and D had a slight copper deposit on the polyethylene mask. Board E had no deposit at all on the polyethylene mask.

These results are summarized in the Table below:

TABLE

| Board | Electroless plating catalyst | Accelerator solution | Through hole plating | Extraneous plating on mask |
|---|---|---|---|---|
| A | Catalytic laminate | — | Poor | Satisfactory: no copper |
| B | Catalytic laminate and activator sol. | 1 min. acidic mild stirring | Good | 40% copper coverage |
| C | Catalytic laminate and activator sol. | 1,5 min. alkaline vigorous stirring | Good | 21% copper coverage |
| D | Catalytic laminate and activator sol. | 3 min. alkaline vigorous stirring | Good | Fair: trace of copper |
| E | Catalytic laminate and activator sol. | 5 min. alkaline vigorous stirring | Good | Satisfactory: no copper |
| F | Catalylic laminate and activator sol. | 10 min. alkaline vigorous stirring | Fair | Satisfactory: no copper |

Example 3

The procedures of Example 2 were repeated except that the smear removal was accomplished by treating at 60°C for 60 minutes with the following solution:

| | |
|---|---|
| $KMnO_4$ | 15,0 g/l |
| Fluorinated alkyl carboxylate | 0,2 g/l |
| pH | 12,6 |

followed by neutralizing, rinsing and treating with 50% NaOH at 95°C for 20 minutes.

Essentially the same results were obtained except that the copper build-up over the fiber bundles in boards B, C, D and E for this Example was thicker than for the corresponding baords B, C, D and E of Example 2.

Example 4

The procedure of Example 2, board E, was repeated for boards designated A, B, C and D except that the accelerator solution was still, i.e., not stirred, and the immersion time in said accelerator solution was 15, 30, 60 and 90 minutes, respectively.

After 60 minutes in the electroless copper bath, boards A, B, C and D were examined.

Board A had continuous copper plating through the holes but approximately 50% electroless copper coverage of the polyethylene mask.

Board B also had continuous copper plating through the holes with no electroless copper plating on the polyethylene mask.

In board C, there were small voids in the copper plating on the hole walls and no copper on the polyethylene mask.

In Board D, there was virtually no copper plating through the holes and none on the polyethylene mask.

Example 5

This Example describes the manufacture of an additive printed circuit board.

Two catalytic, glass cloth reinforced, flame retardant epoxy substrates, each 1,5 mm thick, were prepared by the procedure of Example 10 of US-PS 3,600,330. The catalytic substrates were coated on both sides with the catalytic adhesive described in Example 9 of US-PS 3,779,758. This adhesive had a film thickness of 25 μm. The adhesive coated substrates were drilled with the hole pattern for a plated, through-hole, printed wiring board. An epoxy resist image mask leaving exposed the desired conductor pattern was printed on both sides of each of the adhesive coated substrates. The substrates were adhesion promoted in chromic acid solution, neutralized and rinsed. One of the adhesive coated substrates thus treated was placed directly in the electroless copper bath described below, as a control. The other substrate was treated with the alkaline cleaner-conditioner, rinsed, pre-dipped, activator-treated, rinsed and immersed for 5 min. in the alkaline solution acting as accelerator and catalyst remover and rinsed, all steps as in Example 2. Both substrates were immersed in an electroless copper plating solution of the following formulation:

| | |
|---|---|
| Copper sulfate | 0,025 moles/l. |
| Formaldehyde | 0,4 moles/l. |
| Ethylenediaminetetraacidic acid | 0,07 moles/l. |
| Cyanide ion activity | 0,025 millimoles/l. |
| Alkylphenoxypolyglycidyl phosphate | 0,05 millimoles/l. |
| Temperature | 60°C. |

After 15 minutes plating, the control substrate had no copper deposited thereon while the substrate treated with the activator and accelerator solution had 75% of the hole walls plated and 95% of the surface conductor pattern plated. There was no plating on the mask area. After 90 minutes plating, the control substrate had approximately 5% of the hole walls plated and about 60% of the surface conductors plated while the substrate treated with the activator and accelerator solutions according to the invention had 100% coverage on the hole walls and 100% coverage on the surface conductors. There was still no plating on the resist mask. After 24 hours plating of the panel treated with the activator and accelerator, the conductor pattern was completely covered with 35 μm of copper and there was no deposit of copper on the resist mask.

Example 6A

The following Example illustrates the application of the invention to substrates that do not contain catalytic filler.

A wire scribed circuit board was prepared according to the procedure disclosed in US-PS 3,674,914. A prepreg (a sheet of glass cloth impregnated with epoxy resin) was coated on both sides with a non-catalytic adhesive and laminated to a sheet of non-catalytic epoxy glass laminate 1,6 mm thick. Wire circuit patterns were scribed on the adhesive surface using insulating wire with an overall diameter of 0,186 mm. After the wiring step, a layer of non-catalytic prepreg was laminated by heat and pressure over the wire scribed circuit pattern. The board was then coated on both sides with a hydrophobic polyethylene film by means of a pressure sensitive adhesive. Holes, 1,17 mm in diameter, were drilled through the board intersecting and cutting the scribed wiring pattern at points where electrical connections were to be made. The hole walls were chemically cleaned as described in Example 1 above, and, after rinsing, were prepared for electroless copper plating by the following procedure:

1. The board was immersed in an alkaline cleaner-conditioner solution for 5 minutes at 55°C with rack agitation as described in step 1 of Example 2.
2. The board was rinsed for 3 minutes in running water.
3. The board was immersed in 60 g/l sodium persulfate solution.
4. The board was rinsed for 3 minutes in running water.
5. The board was immersed in a solution containing 100 ml/l sulfuric acid.
6. The board was rinsed for 3 minutes in running water.
7. The board was immersed in an acidic predip solution of 5 g/l tin chloride dissolved in a 200 g/l sodium chloride brine.
8. The board was immersed for 5 minutes in an activator solution containing 150 mg/l palladium, prepared by dissolving 32 ml of the concentrate solution of Example 1, US-PS 3,961,109 in 1 liter of acidic predip solution.
9. The board was rinsed for 3 minutes in running water.
10. The board was immersed for 5 minutes in an alkaline accelerator solution of the following composition:

| | |
|---|---|
| Hydroxyethylethylenediaminetriacetate | 11,25 ml/l |
| Sodium hydroxide | 3,0 g/l |
| Alkylphenoxypolyglycidylphosphate | 0,02 g/l |

the balance being water, using the rack agitation conditions described in step 1 of Example 2, and vigorously stirring using the two-speed mixer described in Example 1 operating between 1200 and 1600 revolutions per minute.

11. The board was rinsed for 3 minutes in running water.
12. The board was immersed in the electroless copper plating solution of Example 1.

0 176 736

After three hours in the copper plating solution, the board was examined.

There was a copper layer of 8 μm which was void-free and free of fissures and breaks, plated uniformly on the hole walls. The polyethylene mask on the surface was completely free of copper deposits.

Example 6B

Example 6A was repeated except that as the alkaline cleaner-conditioner, the cleaner-conditioner of Example 2 was used.

Example 7

This Example illustrates the importance of the alkaline accelerator comprising a chelating agent.

Three wire scribed circuit boards designated A, B and C, were prepared. An epoxy-glass prepreg sheet, which had dispersed throughout a catalyst for electroless metal deposition, was coated on both sides with an adhesive also containing a catalyst for electroless metal deposition and bonded to a sheet of catalytic epoxy-glass laminate of 1,6 mm thickness. Wire circuit patterns were scribed on the adhesive surface using insulated wire with an overall diameter of 0,186 mm. A layer of catalytic prepreg was laminated by heat and pressure over the wire scribed circuit pattern. Each board was then coated on both sides with a polyethylene film by means of a pressure sensitive adhesive and holes, 1,17 mm in diameter, were drilled through each board where required. These holes exposed some of the catalyst contained in the laminate and in the adhesive. The holes were chemically cleaned as described in Example 1 above and, after rinsing, were prepared for electroless copper plating by the following procedure:

1. Each board A, B and C was treated according to the procedures set forth in steps 1 to 9 of Example 6A.

2. Board A was immerssd for 5 minutes in the alkaline solution described in Example 6A, using the rack agitation conditions described in step 1 of Example 2 and vigorously stirring using a mixer operating between 1200 and 1600 revolutions per minute.

3. Board A was rinsed for 3 minutes in running water.

4. Board A was immersed in the electroless copper plating solution of Example 1.

5. Board B was immersed for 5 minutes in a conventional acidic accelerator solution of 100 ml/l fluoboric acid and 10 ml/l of hydroxy ethylene diaminetriacetic acid (HEDTA) and using the rack agitation conditions described in step 1 of Example 2.

6. Steps 3 and 4 above were repeated for board B.

7. Board C was immersed for 5 minutes in an acidic accelerator solution of 200 g/l sodium chloride and 10 ml/l hydrochloric acid and using the rack agitation conditions of step 1, Example 2.

8. Steps 3 and 4 above were repeated for board C. After 5 minutes of electroless copper plating, board A had a uniform copper film on the hole walls, but there was no copper deposit on the surface.

After 5 minutes of electroless copper plating, boards B and C had a uniform copper film on the hole walls. However, 75% of the surface of the polyethylene mask was also covered by a uniform copper film.

After 3 hours plating, board A had 8 μm of copper plated on the hole walls and no copper deposited on the surface of the polyethylene resist.

Example 8A

In order to quantify the removal of palladium from the hydrophobic mask surface, the following test was performed:

Four epoxy-glass substrates were prepared with a polyethylene resist film bonded to both surfaces thereof. No holes were drilled in the substrate. Three substrates were treated following the procedures of steps 1 to 9 of Example 6A. A first substrate was then treated in the alkaline accelerator solution of Example 6A as described in the said Example.

A second substrate was treated in the acid accelerator solution of step 5 of Example 7 and as described therein.

A third substrate received no further treatment.

A fourth substrate was designated as a control and received no further treatment at all.

The edges of all four substrates were trimmed so that of the total surface exposed to palladium activator, only the polyethylene surfaces remained.

The substrates were each soaked in an aliquot of acqua regia to strip off palladium from the polyethylene resist. The acqua regia aliquots were analyzed by Atomic Absorption Spectrophotometry with the following results:

| | Panel treatment | Pd on resist surface |
|---|---|---|
| 1. | Alkaline accelerator | 0,0012 mg/cm$^2$ |
| 2. | Acid accelerator | 0,0048 mg/cm$^2$ |
| 3. | No accelerator | 0,0064 mg/cm$^2$ |
| 4. | Control | 0,0010 mg/cm$^2$ |

The palladium analysis of the control and board No. 1 shows the lower limit of the test method, i.e., the method cannot detect any difference between 0,001 mg/cm$^2$ and 0 mg/cm$^2$.

This illustrates that the alkaline accelerator treatment is effective in reducing the palladium absorbed on a hydrophobic surface to a level approximating the control which was not treated with a palladium activator. The acid accelerator is not effective in removing palladium from the hydrophobic surface.

Example 8B

Example 8A was repeated with two substrates being prepared for each condition. One of the susbtrates was electrolessly plated with copper using the electroless copper plating bath solution of Example 5, and another of the substrates was analyzed for palladium on its surface. Also, Example 8A was repeated with two substrates as described above except that the immersion in the alkaline accelerator was for 2 minutes. The results are set forth in the Table below:

TABLE

| Selective seeding | Area (cm$^2$) | mg/l | mg/cm$^2$ | Plating on surface |
|---|---|---|---|---|
| Control | 186 | 0,08 | 0 | none |
| No acceleration | 198 | 1,92 | 0,0097 | 75% |
| Fluoroboric acid accelerator | 208 | 1,44 | 0,0069 | 100% |
| 2 min. alkaline accelerator | 206 | 0,30 | 0,0015 | 5% |
| 5 min. alkaline accelerator | 202 | 0,20 | 0,0010 | none |

As shown in the Table above, after acceleration, the amount of palladium left on per cm$^2$ of the resist should be below 0,002 mg/cm$^2$ to avoid subsequent deposition of electroless metal on the resist surface.

**Claims**

1. Process for selective metallization of insulating substrates comprising the steps of applying a hydrophobic masking layer to said substrate, said masking layer covering all areas not to be metallized and leaving exposed areas to be provided with a metal deposit; contacting the substrate provided with said masking layer with an agent capable of depositing catalytic species for promoting metal deposition; treating said substrate and masking layer with a solution for removing catalytic species from the surface of the masking layer; and contacting the substrate with a solution capable of electrolessly forming metal deposits on the unmasked areas of said substrate, characterized in that said solution for removing catalytic species from the surface of said masking layer comprises a chelating agent for the catalytic species and has a pH of between 10 and 14; and that the surface is exposed to said solution for a time sufficient for removing essentially all the catalytic species from the masking layer and leaving catalytic species on unmasked portions of the substrate.

2. The process of claim 1, characterized in that said solution comprising the chelating agent at the same time enhances the catalytic activity of said catalytic species on unmasked portions of the substrate.

3. The process of claim 1, characterized in that said solution comprising the chelating agent is agitated when in contact with the substrate.

4. The process of claims 1 to 3, characterized in that said chelating agent is selected from amino acids, alkanolamines and polyfunctionol carboxylates.

5. The process of claim 4, characterized in that the amino acid is selected from hydroxy-ethylenediamine triacetic acid and salts thereof, glycine and nitrilotriacetic acid.

6. The process of claim 4, characterized in that said alkanolamine is selected from hydroxy-ethylenediamine tetraacetic acid and salts thereof and ethylene diamine tetrapropanol.

7. The process of claim 4, characterised in that said polyfunctional carboxylate comprises a citrate or a tartrate.

8. The process of claim 1, characterized in that the agent comprising species capable of promoting metal deposition is a solution comprising palladium, tin and chloride.

9. The process of claim 8, characterized in that the palladium concentration left on the masking layer after treatment with said solution comprising the chelating agent does not exceed 0,002 mg/cm$^2$.

10. The process of claim 1, characterized in that prior to exposure to the agent comprising species capable of promoting metal deposition the substrate and masking layer are exposed to a cleaner-conditioner solution.

11. The process of one or more of claims 1 to 10, characterized in that said masking layer comprises a resin selected from epoxy novolac, silicones, polyethylene resins, fluorocarbon resins, polyurethane resins, acrylic resins and mixtures of the foregoing.

**0 176 736**

12. The process of claims 1 to 11, characterized in that the substrate is provided with at least one hole and/or blind via cavity, the walls of said hole or cavity not being covered by said masking layer.

13. The process of claim 12, characterized in that the unmasked areas of the substrate and/or hole pattern walls constitute a printed circuit pattern or part of such pattern.

14. The process of claim 12, characterized in that the substrate is provided with at least one wire scribed conductor affixed to the surface or embedded in said substrate and with at least one hole intersecting or exposing said wire conductor.

### Patentansprüche

1. Verfahren zur selektiven Metallisieren von Isolierstoff-Trägern nach den folgenden Verfahrensschritten: Aufbringen einer hydrophoben Maskenschicht auf alle Bezirke des Trägers, die nicht metallisiert werden sollen, wobei die zu metallisierenden Bezirke unbedeckt bleiben; Behandeln der gesamten Oberfläche des Trägers mit einer Lösung zum Ausbilden von auf die stromlose Metallabscheidung katalytisch wirksamen Keimen; Behandeln der Oberfläche mit einer Lösung zum Entfernen der auf die stromlose Metallabscheidung katalytisch wirksamen Keime von der Maskenschicht; und Ausbilden einer Metallschicht auf den unmaskierten Oberflächenbezirken in einer stromlos Metall abscheidenden Badlösung, dadurch gekennzeichnet, daß die Lösung zum Entfernen der katalytisch wirksamen Keime von der Maskenschicht einen Chelatbildner für die katalytisch wirksamen Keime enthält und ihr pH Wert zwischen 10 und 14 beträgt; und daß die Behandlungsdauer mit der genannten Lösung ausreicht, um praktisch alle katalytisch wirksamen Keime von der Maskenschicht zu entfernen, während die auf der nicht maskierten Oberfläche befindlichen Keime nicht antfernt werden.

2. Verfahren nach Anspruch 1, dadurch gekennzeichnet, daß die einen Chelatbildner für die katalytisch wirksamen Keime enthaltende Lösung gleichzeitig die Aktivität der katalytisch wirksamen Keime in den nicht maskierten Bereichen verstärkt.

3. Verfahren nach Anspruch 1, dadurch gekennzeichnet, daß die einen Chelatbildner enthaltende Lösung während des Kontaktes mit der Trägeroberfläche bewegt wird.

4. Verfahren nach den Ansprüche 1 bis 3, dadurch gekennzeichnet, daß der Chelatbildner aus der Gruppe der Aminosäuren, der Alkanolamine und der polyfunktionalen Carboxylate ausgewählt wird.

5. Verfahren nach Anspruch 4, dadurch gekennzeichnet, daß die Aminosäure aus Hydroxyethylendiamin-Triessigsäure und deren Salzen, Glyzin und Nitriloessigsäure ausgewählt ist.

6. Verfahren nach Anspruch 4, dadurch gekennzeichnet, daß das Akanolamin aus Hydroxyethylenediamin-Tetraessigsäure und deren Salzen sowie Ethylendiamin-Tetrapropanol ausgewählt ist.

7. Verfahren nach Anspruch 4, dadurch gekennzeichnet, daß das polyfunktionale Carboxylat Zitrate oder Tartrate enthält.

8. Verfahren nach Anspruch 1, dadurch gekennzeichnet, daß die auf die stromlose Metallabscheidung katalytisch wirksamen Keime enthaltende Lösung Palladium, Zinn und Chloride enthält.

9. Verfahren nach Anspruch 8, dadurch gekennzeichnet, daß die Konzentration des Palladiums auf der Maskenschicht nach Behandlung mit der erfindungsgemäßen, einen Chelatbildner enthaltenden Lösung 0,002 mg/cm² nicht übersteigt.

10. Verfahren nach Anspruch 1, dadurch gekennzeichnet, daß vor dem Aufbringen der auf die stromlose Metallabscheidung katalytisch wirksamen Keime der Träger und die Maskenschicht gereinigt und konditioniert werden.

11. Verfahren nach den Ansprüchen 1 bis 9, dadurch gekennzeichnet, daß die genannte Maskenschicht ein Harz aus der Gruppe der Novolacke, Silikone, Polyethylenharze, Fluorokarbonharze, Polyurethanharze, Akrylharze und Mischungen der genannten enthält.

12. Verfahren nach den Ansprüche 1 bis 11, dadurch gekennzeichnet, daß der Träger mindestens ein Loch und/oder ein Sackloch enthält, dessen Wandungen nicht mit der genannten Maskenschicht bedeckt sind.

13. Verfahren nach Anspruch 12, dadurch gekennzeichnet, daß die nicht mit der Maskenschicht bedeckten Bezirke des Trägers sowie die Lochwandungen ein gedrucktes Schaltungsmuster oder Teile eines solchen darstellen.

14. Verfahren nach Anspruch 12, dadurch gekennzeichnet, daß der Träger mit mindestens einem, auf der Trägeroberfläche befestigten oder in diese eingebetteten Drahtleiterzug und mit wenigstens einem, diesen Leiterzug durchtrennenden Loch versehen ist.

### Revendications

1. Procédé de métallisation sélective de substrats isolants, comprenant les étapes consistant à déposer une couche de masquage hydrophobe sur ledit substrat, ladite couche de masquage recouvrant toutes les zones ne devant pas être métallisées et laissant des zones exposées qui doivent être pourvues d'un dépôt de métal; à faire entrer en contact le substrat pourvu de ladite couche de masquage avec un agent capable de déposer des substances catalytiques pour favoriser un dépôt de metal; à traiter ledit substrat et ladite couche de masquage avec une solution permettant d'enlever des substances catalytiques de la surface de la couche de masquage; et à faire entrer en contact le substrat avec une solution capable de former non-électrolytiquement des dépôts métalliques sur les zones non-masquées dudit substrat, caractérisé en ce que ladite solution permettant d'enlever les substances catalytiques de la surface de ladite couche de masquage contient un agent de chélation pour les substances catalytiques et a un pH compris entre 10 et 14; et en ce que la surface est exposée à ladite solution pendant un temps suffisant pour enlever pratiquement toutes les substances catalytiques de la couche de masquage et pour laisser des substances catalytiques sur des parties non-masquées du substrat.

2. Procédé selon la revendication 1, caractérisé en ce que ladite solution contenant l'agent de chélation améliore simultanément l'activité catalytique desdites substances catalytiques sur des parties non-masquées du substrat.

3. Procédé selon la revendication 1, caractérisé en ce que ladite solution contenant l'agent de chélation est agitée lors de son entrée en contact avec le substrat.

4. Procédé selon l'une quelconque des revendications 1 à 3, caractérisé en ce que ledit agent de chélation est choisi parmi des acides amino, des alcanolamines et des carboyxlates polyfonctionnels.

5. Procédé selon la revendication 4, caractérisé en ce que l'acide amino est choisi parmi l'acide hydroxy-éthylènediamine triacétique et des sels de celui-ci, la glycine et l'acide nitrilotriacétique.

6. Procédé selon la revendication 4, caractérisé en ce que ladite alcanolamine est choisie parmi l'acide hydroxy-éthylènediamine tétraacétique et des sels de celui-ci et l'éthylènediamine tétrapropanol.

7. Procédé selon la revendication 4, caractérisé en ce que ledit carboxylate polyfonctionnel comprend un citrate ou un tartrate.

8. Procédé selon la revendication 1, caractérisé en ce que l'agent contenant des substances capables de favoriser un dépôt de métal est une solution contenant du palladium, de l'étain et un chlorure.

9. Procédé selon la revendication 8, caractérisé en ce que la concentration en palladium laissé sur la couche de masquage après traitement avec ladite solution contenant l'agent de chélation ne doit pas dépasser 0,002 mg/cm$^2$.

10. Procédé selon la revendication 1, caractérisé en ce que, avant une exposition à l'agent contenant des substances capables de favoriser un dépôt de métal, le substrat et la couche de masquage sont exposés à une solution de nettoyage-conditionnement.

11. Procédé selon l'une quelconque des revendications 1 à 10, caractérisé en ce que ladite couche de masquage contient une résine choisie parmi des résines époxy novolac, de silicones, de polyéthylène, fluorocarbonées, de polyuréthane, acryliques et des mélanges desdites résines.

12. Procédé selon l'une quelconque des revendications 1 à 11, caractérisé en ce que le substrat est pourvu d'au moins un trou et/ou une cavité borgne, les parois dudit trou ou de ladite cavité n'étant pas recouvertes par ladite couche de masquage.

13. Procédé selon la revendication 12, caractérisé en ce que les zones non masquées du substrat et/ou des parois du motif de trous constituent un motif de circuit imprimé ou une partie dudit motif.

14. Procédé selon la revendication 12, caractérisé en ce que le substrat est pourvu d'au moins un conducteur défini par un fil et fixé sur la surface ou bien noyé dans ledit substrat et, également, d'au moins un trou coupant ou exposant ledit conducteur filaire.

13